Europäisches Patentamt

(19) European Patent Office

Office européen des brevets

(11) Numéro de publication : **0 307 275 B1**

(12) **FASCICULE DE BREVET EUROPEEN**

(45) Date de publication du fascicule du brevet :
27.11.91 Bulletin 91/48

(21) Numéro de dépôt : 88402151.0

(22) Date de dépôt : 24.08.88

(51) Int. Cl.⁵ : **H03H 19/00**

(54) **Quadripôle de filtrage à capacités commutées pour linéariser la réponse phase/fréquence dudit filtre.**

(30) Priorité : 26.08.87 FR 8711962

(43) Date de publication de la demande :
15.03.89 Bulletin 89/11

(45) Mention de la délivrance du brevet :
27.11.91 Bulletin 91/48

(84) Etats contractants désignés :
DE FR GB IT NL

(56) Documents cités :
**ARCHIV FÜR ELEKTRONIK UND
ÜBERTRAGUNGSTECHNIK, vol. 36, no. 4, avril
1982, pages 141-147, Würzburg, DE; B. HUBER
et al.: "Design of a switched-capacitor filter
for viewdata modems"
PATENT ABSTRACTS OF JAPAN, vol. 5, no. 78
(E-58)[750], 22 mai 1981, page 37 E 58; &
JP-A-56 25 820 (NIPPON DENKI K.K.) 12-
03-1981**

(73) Titulaire : ETAT FRANCAIS représenté par le
Ministre Délégué des Postes et
Télécommunications
(CENTRE NATIONAL D'ETUDES DES
TELECOMMUNICATIONS) 38-40 rue du
Général Leclerc
F-92131 Issy-les-Moulineaux (FR)

(72) Inventeur : Senn, Patrice
13, Grande Rue
F-38000 Grenoble (FR)
Inventeur : Tawfik, Mohamed Sameh
150, Galerie de l'Arlequin
F-38100 Grenoble (FR)

(74) Mandataire : Netter, André et al
Cabinet NETTER, 40, rue Vignon
F-75009 Paris (FR)

## Description

La présente invention concerne la réalisation de filtres échantillonnés à capacités commutées. Plus particulièrement, elle a pour objet un quadripôle de filtrage à capacités commutées pour linéariser la réponse phase/fréquence du filtre. Elle trouve une application dans les appareils de télécommunication tels que modem, appareil de transmission de données et de vidéocommunication qui demandent, sous la forme de circuits intégrés, des filtres à réponse phase/fréquence linéaire car l'oeil humain est sensible à la distorsion de la phase/fréquence desdits filtres.

D'une façon générale, les filtres échantillonnés à capacités commutées sont agencés sous la forme de circuits intégrés selon une structure dite en échelle constituée de circuits intégrateurs interconnectés entre eux et dont les entrées respectives sont équipées de capacités commutées selon deux états d'horloge disjoints.

On connaît des filtres à capacités commutées dits à phase minimale dont la réponse phase/fréquence n'est pas linéaire mais dont le déphasage entre l'entrée et la sortie du filtre est minimal. Parmi les filtres à phase minimale, il existe les filtres dits de Chebyschev dont la bande passante est droite ainsi que son atténuation en amplitude/fréquence. La coupure de la courbe de réponse amplitude/fréquence est raide tandis que la courbe de réponse phase/fréquence croît irrégulièrement au niveau de la fréquence de transition du filtre, c'est-à-dire qu'au niveau de cette fréquence de transition, le temps de propagation des signaux ou temps de groupe augmente. Il existe aussi les filtres dits de Bessel dont la coupure de la courbe de réponse amplitude/fréquence est molle. Le temps de groupe est constant, c'est-à-dire que la phase varie linéairement avec la fréquence ou bien le déphasage entre l'entrée et la sortie du filtre est linéaire avec la fréquence. Les filtres à phase minimale ne sont pas satisfaisants car la phase (Chebyschev) ne varie pas linéairement avec la fréquence ou l'atténuation en amplitude (Bessel) est molle et non curviligne.

Pour remédier à ces inconvénients, l'article "Synthesis of Switched-Capacitor Circuits Simulating Canonical Reactance Sections", Georg J. Smolka, IEEE Trans. Circuits Systems, Vol. Cas-32, pages 513-521, Juin 1985, propose un filtre à capacités commutées de type à phase non minimale dont la structure ne modifie pas l'atténuation de l'amplitude/fréquence mais modifie la réponse phase/fréquence afin de la linéariser. Ce filtre est agencé selon une structure en échelle et dérive d'un circuit LC à éléments passifs transformés selon un graphe de fluence. Il comprend cinq circuits intégrateurs interconnectés entre eux dont trois d'entre eux font partie intégrante du circuit en échelle. Il comprend en outre deux inverseurs qui sont par exemple deux amplificateurs opérationnels inverseurs interposés entre les trois intégrateurs du circuit en échelle et les deux autres circuits intégrateurs qui s'insèrent dans le circuit en échelle afin de linéariser la réponse phase/fréquence.

Néanmoins, ce genre de filtre n'est pas satisfaisant car il comporte un nombre d'éléments actifs (amplificateur opérationnel, inverseur, capacités commutées) trop élevé. De plus, six phases d'horloge sont nécessaires au fonctionnement du filtre, ce qui complique considérablement le générateur d'horloge. Enfin, l'insertion de ce filtre à six phases d'horloge dans un circuit en échelle classique à deux phases d'horloge constitue un problème technologique difficile à résoudre.

L'invention a pour but d'apporter une solution à ce problème. A cette fin, elle propose un quadripôle de filtrage à capacités commutées permettant de linéariser la réponse phase/fréquence en n'utilisant que deux phases d'horloge pour la commutation des capacités reliées aux entrées respectives des circuits intégrateurs.

L'invention porte sur un quadripôle de filtrage à capacités commutées, du type comprenant, entre deux bornes d'entrée et deux bornes de sortie, au moins trois circuits intégrateurs possédant chacun deux entrées équipées de capacités commutées selon deux états d'horloge disjoints, et qui sont interconnectés pour former un filtre échantillonné de réponse amplitude/fréquence choisie.

Selon une définition générale de l'invention, le quadripôle de filtrage comporte deux autres circuits intégrateurs dont les entrées respectives sont équipées de capacités commutées selon deux états d'horloge disjoints et qui sont interconnectés entre eux et avec les premiers pour linéariser la réponse phase/fréquence dudit filtre.

On connaît déjà un quadripôle de filtrage, dans lequel un premier circuit intégrateur comporte deux entrées dont l'une est reliée à la première borne d'entrée et dont la sortie est reliée à la seconde borne d'entrée, dans lequel un second circuit intégrateur comporte deux entrées dont la première est reliée à la sortie du premier circuit intégrateur et dont la sortie forme la seconde entrée du premier circuit intégrateur et dans lequel un troisième intégrateur comporte deux entrées dont la première est reliée à la sortie du second circuit intégrateur, dont la seconde entrée est reliée à la première borne de sortie et dont la sortie est reliée à la seconde borne de sortie ainsi qu'à la seconde entrée du second circuit intégrateur.

Selon une caractéristique de l'invention, les premier et troisième circuits intégrateurs sont munis d'une entrée supplémentaire, le quatrième circuit intégrateur comprend trois entrées, dont la première est reliée à la sortie du premier circuit intégrateur et la seconde est reliée à la sortie du troisième circuit intégrateur et dont la sortie est reliée aux supplémentaires des premier et troisième circuits intégrateurs et le cinquième circuit intégrateur comprend une seule entrée reliée elle aussi à la sortie du quatrième circuit intégrateur et dont la sortie est reliée à la troisième entrée du quatrième circuit intégrateur.

Selon un aspect de l'invention, certains au moins des circuits intégrateurs comprennent : un amplificateur opérationnel, une entrée non inverseuse reliée à la masse et une entrée inverseuse reliée aux différentes entrées desdits circuits intégrateurs via des capacités commutées.

Selon une autre caractéristique de l'invention, les différentes entrées d'un circuit intégrateur sont définies chacune par : une capacité, un commutateur entrée propre à établir une liaison électrique entre l'une des armatures de la capacité et soit l'entrée, soit la masse, un organe commutateur de liaison étant propre à établir une liaison électrique entre l'autre armature de la capacité et soit l'entrée inverseuse, soit la masse.

En pratique, l'organe commutateur de liaison comprend un commutateur propre à établir une liaison électrique entre un noeud et soit l'entrée inverseuse soit la masse, les différentes autres armatures des capacités étant reliées ensemble au noeud.

Selon une variante du dispositif de l'invention, l'organe commutateur de liaison comprend plusieurs commutateurs propres chacun à établir une liaison électrique entre chaque autre armature des capacités et soit un point de contact électrique, soit la masse, chaque point de contact électrique étant relié ensemble à l'entrée inverseuse.

Selon un autre aspect de l'invention, chaque entrée inverseuse des circuits intégrateurs est reliée par une capacité à la sortie des amplificateurs opérationnels de chaque circuit intégrateur.

Selon un mode de réalisation préféré du dispositif selon l'invention, la sortie du premier intégrateur est reliée par une capacité à l'entrée inverseuse de l'amplificateur du troisième circuit intégrateur et la sortie du troisième intégrateur est reliée par une autre capacité à l'entrée inverseuse de l'amplificateur opérationnel du premier circuit intégrateur, ce qui permet d'obtenir un filtre échantillonné de type elliptique.

D'autres caractéristiques et avantages de l'invention apparaîtront à l'examen de la description détaillée ci-après, et des dessins annexés, sur lesquels :

— la figure 1 représente schématiquement un filtre échantillonné à capacités commutées comprenant trois circuits intégrateurs interconnectés entre eux selon l'art antérieur ;

— la figure 2 représente schématiquement les éléments constitutifs et essentiels d'un filtre à capacités commutées selon l'invention ;

— la figure 3 représente une variante de l'organe commutateur de liaison selon l'invention ;

— la figure 4 illustre schématiquement un filtre à éléments passifs équivalent au quadripôle de filtrage selon l'invention ;

— la figure 5 représente un filtre elliptique à capacités commutées du septième ordre selon l'invention ; et

— la figure 6 représente les courbes de réponse du filtre de la figure 5 en fonction de la fréquence selon l'invention.

Les dessins annexés comportent à de nombreux titres des éléments de caractère certain. Ils pourront donc non seulement servir à éclairer la description ci-après, mais aussi contribuer à la définition de l'invention, le cas échéant.

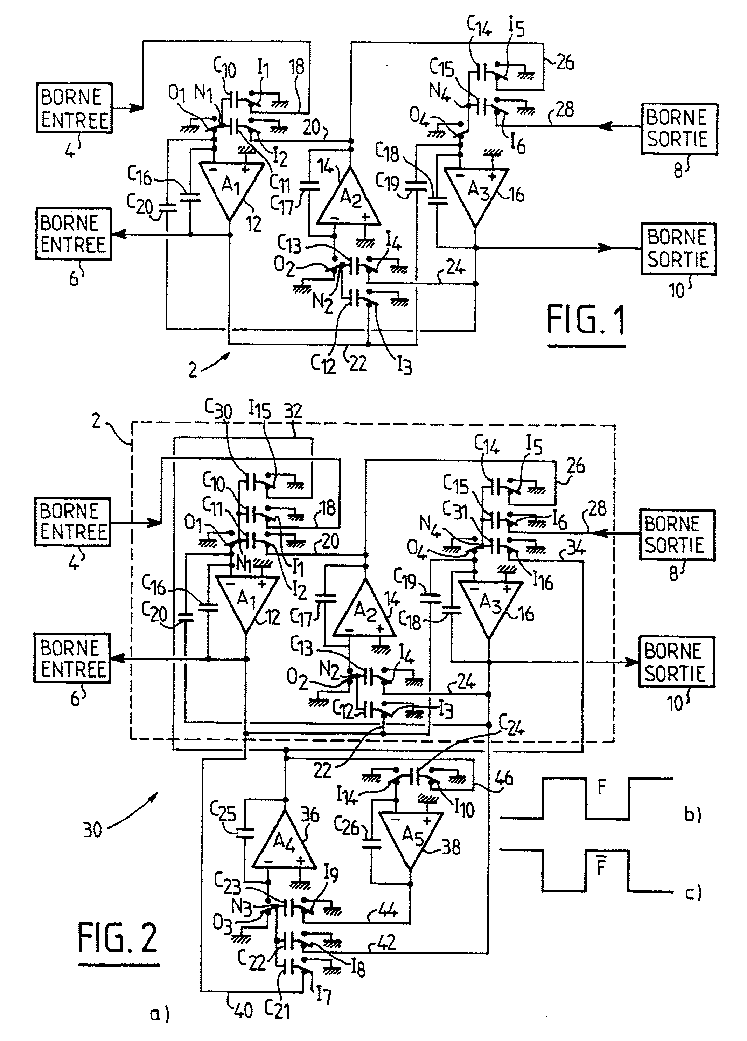

Sur la figure 1, la référence 2 désigne un quadripôle de filtrage à capacités commutées bien connu de l'homme de l'art. Le quadripôle 2 comprend entre deux bornes d'entrée 4, 6 et deux bornes de sortie 8, 10, trois circuits intégrateurs agencés selon une structure en échelle. Les circuits intégrateurs 12, 14 et 16 sont interconnectés entre eux pour former un filtre échantillonné de réponse amplitude/fréquence choisie, par exemple un filtre de type passe-bas.

Le circuit intégrateur 12 comporte deux entrées 18 et 20. L'entrée 18 est reliée à la borne d'entrée 4 et la sortie du circuit intégrateur 12 est reliée à la borne d'entrée 6.

Le circuit intégrateur 14 comporte deux entrées 22 et 24. L'entrée 22 est reliée à la sortie du circuit intégrateur 12. La sortie du circuit intégrateur 14 forme l'entrée 20 du circuit intégrateur 12.

Le circuit intégrateur 16 comporte deux entrées 26 et 28. L'entrée 26 est reliée à la sortie du circuit intégrateur 14. L'entrée 28 est reliée à la borne de sortie 8. La sortie du circuit intégrateur 16 est reliée à la borne de sortie 10 ainsi qu'à l'entrée 24 du circuit intégrateur 14.

Les circuits intégrateurs 12, 14 et 16 comprennent chacun un amplificateur opérationnel respectivement A1, A2 et A3, une entrée non inverseuse reliée à la masse et une entrée inverseuse reliée aux différentes entrées desdits circuits intégrateurs via les capacités commutées.

Les entrées 18 et 20 du circuit intégrateur 12 sont définies respectivement par une capacité C10 et une capacité C11 et respectivement par un commutateur entrée I1 et un commutateur entrée I2 établissant chacun une liaison électrique entre respectivement l'une des armatures de la capacité C10 et soit la masse soit l'entrée 18 et entre l'une des armatures de la capacité C11 et soit la masse soit l'entrée 20. Un organe commutateur de liaison O1 établit une liaison électrique entre l'autre armature de la capacité C10 et de la capacité C11 et soit l'entrée inverseuse du circuit intégrateur 12 soit la masse. L'organe commutateur de liaison O1 comprend un commutateur établissant une liaison électrique entre un noeud N1 et soit l'entrée inverseuse du circuit intégrateur 12 soit la masse tandis que les différentes autres armatures des capacités C10 et C11 sont reliées ensemble au noeud N1.

Les entrées 22, 24 du circuit intégrateur 14 et les entrées 26 et 28 du circuit intégrateur 16 sont définies de la même façon que les entrées 18 et 20.

On remarquera que chaque entrée inverseuse des circuits intégrateurs 12, 14 et 16 est reliée respectivement par une capacité C16, C17 et C18 à la sortie de l'amplificateur opérationnel associé à chaque circuit intégrateur.

En pratique, lorsque le quadripôle de filtrage 2 est de type elliptique, la sortie du circuit intégrateur 12 est reliée par une capacité C19 à l'entrée inverseuse de l'amplificateur du circuit intégrateur 16 et la sortie du circuit intégrateur 16 est reliée par une capacité C20 à l'entrée inverseuse de l'amplificateur opérationnel du circuit intégrateur 12.

Le quadripôle de filtrage 2 est dit biphasé car les capacités C10 à C15 commutent selon deux états d'horloge disjoints :

un état dit de travail et un état dit de repos.

Afin de linéariser la réponse phase/fréquence du filtre 2, deux autres circuits intégrateurs dont les entrées respectives sont équipées de capacités commutées selon deux états d'horloge disjoints, sont interconnectés entre eux et avec les circuits intégrateurs du quadripôle 2.

Sur la figure 2, la référence 30 désigne le quadripôle de filtrage selon l'invention. Il comprend, entre les bornes d'entrée 4 et 6 et les bornes de sortie 8 et 10, le quadripôle de filtrage décrit en référence à la figure 1. Les circuits intégrateurs 12, 16 sont munis respectivement d'une entrée supplémentaire 32, 34. Deux circuits intégrateurs supplémentaires 36 et 38 sont interconnectés entre eux et avec les circuits intégrateurs 12, 14 et 16 afin de linéariser la réponse phase/fréquence du quadripôle du filtrage 30. L'entrée 32 est définie par un interrupteur I15 et par une capacité C30 dont l'une des armatures est reliée à l'interrupteur I15 et dont l'autre armature est reliée au noeud N1. L'entrée 34 est définie par un interrupteur I16 et par une capacité C31 dont l'une des armatures est reliée à l'interrupteur I16 et dont l'autre armature est reliée au noeud N4.

Le circuit intégrateur 36 comprend trois entrées 40, 42, 44. L'entrée 40 est reliée à la sortie du circuit intégrateur 12. L'entrée 42 est reliée à la sortie du circuit intégrateur 16. La sortie du circuit intégrateur 36 est reliée aux entrées supplémentaires 32 et 34 des circuits intégrateurs 12 et 16.

Le circuit intégrateur 38 comprend une seule entrée 46 reliée elle aussi à la sortie du circuit intégrateur 36. La sortie du circuit intégrateur 38 est reliée à l'entrée 44 du circuit intégrateur 36.

Les circuits intégrateurs 36 et 38 comprennent respectivement un amplificateur opérationnel A4 et A5, une entrée non inverseuse reliée à la masse et une entrée inverseuse reliée aux différentes entrées desdits circuits intégrateurs 36 et 38 via des capacités commutées.

Les entrées 40, 42 et 44, du circuit intégrateur 36 sont définies respectivement par des capacités C21, C22 et C23 et par des commutateurs entrée I7, I8 et I9 établissant une liaison électrique entre l'une des armatures des capacités respectivement C21, C22 et C23 et soit la masse soit respectivement l'entrée 40, 42 et 44. Un organe commutateur de liaison O3 établit une liaison électrique entre l'autre armature des capacités respectivement C21, C22 et C23 et soit l'entrée inverseuse soit la masse.

L'organe commutateur de liaison O3 comprend un commutateur établissant une liaison électrique entre un noeud N3 et soit l'entrée inverseuse de l'amplificateur A4 du circuit intégrateur 36 soit la masse tandis que les différentes autres armatures des capacités C21, C22 et C23 sont reliées ensemble au noeud N3.

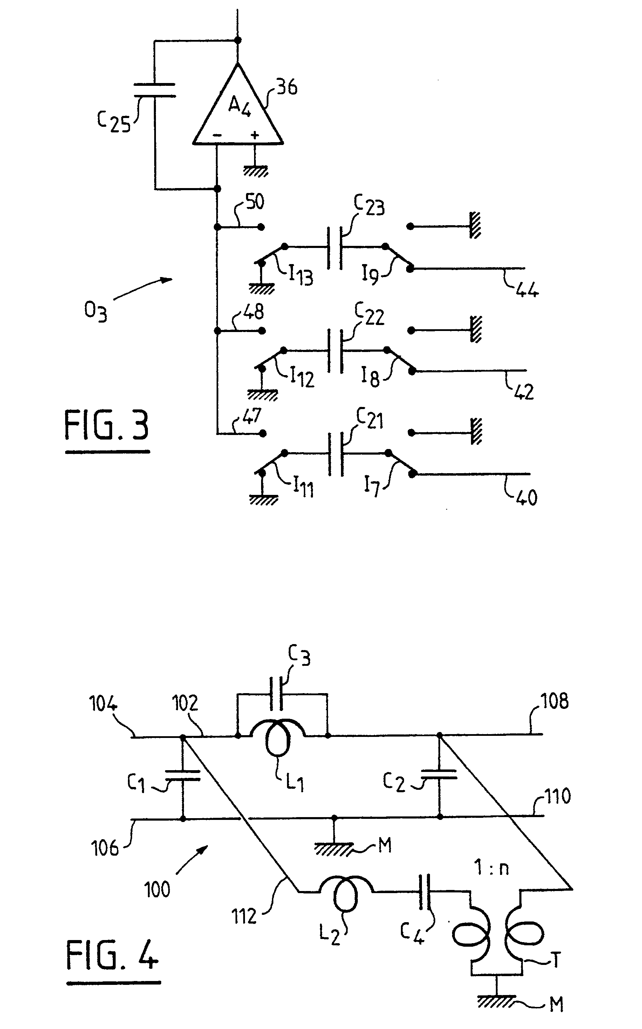

On fait maintenant référence à la figure 3, qui illustre une variante de l'organe commutateur de liaison O3. Sur la figure 3, on voit les entrées 40, 42 et 44 définies respectivement par les couples commutateurs capacités I7-C21, I8-C22 et I9-C23. Dans cette variante, l'organe commutateur de liaison O3 comprend trois commutateurs I11, I12 et I13 établissant respectivement une liaison électrique entre chaque autre armature des capacités C21, C22 et C23 et soit des points de contact électrique respectivement 47, 48 et 50 soit la masse, les points de contact électrique 47, 48 et 50 sont reliés ensemble à l'entrée inverseuse du circuit intégrateur 36.

On fait référence à nouveau à la figure 2. On voit que chaque entrée inverseuse des circuits intégrateurs 36, 38 est reliée respectivement par une capacité C25 et une capacité C26 à la sortie de l'amplificateur opérationnel de chaque circuit intégrateur 36 et 38.

On remarque que l'entrée 46 du circuit intégrateur 38 est définie par la capacité C24, par l'interrupteur I10 établissant une liaison électrique entre l'une des armatures de la capacité C24 et soit l'entrée 46 soit la masse, et par un commutateur I14 établissant une liaison électrique entre l'autre armature de la capacité C24 et soit la masse soit l'entrée inverseuse du circuit intégrateur 38. Sur la partie B de la figure 2, on a représenté un état d'horloge dit de travail de fréquence F

Sur la partie C on a représenté un état d'horloge dit de repos de fréquence $\overline{F}$.

Les capacités C21, C22, C23 et C24 commutent selon les deux états d'horloge disjoints de fréquence F et $\overline{F}$.

La caractéristique essentielle du quadripôle de filtrage de l'invention est d'associer au quadripôle du filtrage 2 décrit en référence à la figure 1, une structure supplémentaire constituée notamment de deux circuits intégrateurs interconnectés entre eux et avec ceux du quadripôle 2 afin de linéariser la courbe de réponse phase/fréquence sans perturber l'atténuation du filtre. On peut remarquer que la structure supplémentaire branchée en parallèle sur le quadripôle 2 est équivalente à des éléments passifs qui agissent sur la phase afin de la linéariser sans perturber l'amplitude du filtre.

Sur la figure 4, on a représenté un quadripôle de filtrage connu, équivalent à celui décrit en référence à la figure 2 et constitué d'éléments passifs qui permettent d'agir sur la phase sans perturber l'amplitude du filtre.

Sur la figure 4, la référence 100 désigne un filtre à éléments passifs dont la courbe de réponse phase/fréquence est linéaire. Le filtre 100 comprend une cellule de base 102 équivalente au quadripôle de filtrage 2 décrit en référence à la figure 1. La cellule de base 102 comprend, entre deux bornes d'entrée 104 et 106, une capacité C1 branchée entre les deux bornes d'entrée 104 et 106, une capacité C2 branchée entre les bornes de sortie 108 et 110 et une inductance L1 insérée entre l'une des armatures de la capacité C1 et l'une des armatures de la capacité C2. L'autre armature de la capacité C1 et l'autre armature de la capacité C2 étant reliées à la masse. Lorsque le filtre 102 est un filtre dit elliptique, une capacité C3 est reliée en parallèle sur l'inductance L1. Les capacités C1, C2 et l'inductance L1 sont équivalentes au circuit intégrateur 12, 14 et 16.

Entre l'une des armatures de la capacité C1 et l'une des armatures de la capacité C2 est inséré un circuit supplémentaire 112 dont le rôle est d'agir sur la phase du filtre sans perturber son amplitude. Le circuit 112 comprend en série une inductance L2, une capacité C4 et un transformateur T dont le rapport de transformation est 1/n.

Il est établi par l'homme de l'art que le circuit 112, connu de ce dernier, agit sur la phase du filtre sans perturber son amplitude. Les circuits intégrateurs 36 et 38 du quadripôle de filtrage 30 décrit en référence à la figure 2 sont équivalents au circuit 112. On remarque en effet que le quadripôle de filtrage 30 permet d'obtenir quatre zéros complexes symétriques dans le plan complexe représentant la fonction de transfert du filtre. L'homme de l'art comprendra qu'un tel quadruple de zéros complexes permet d'agir sur la phase du filtre sans modifier l'amplitude de celui-ci.

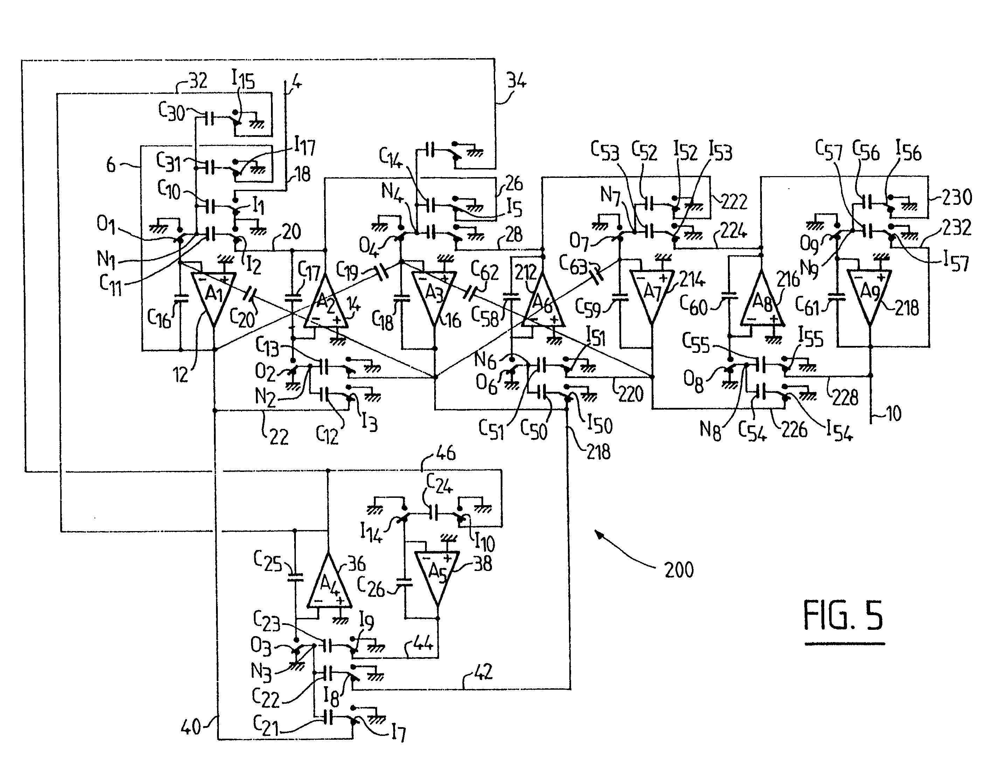

On fait maintenant référence à la figure 5, qui représente un filtre à capacités commutées elliptiques d'ordre 7 selon l'invention. Le quadripôle de filtrage 200 selon l'invention comprend un circuit en échelle constitué de trois circuits intégrateurs 12, 14 et 16 sur lesquels sont branchés les deux circuits intégrateurs 36 et 38 comme décrit en référence à la figure 2 et de quatre autres circuits intégrateurs interconnectés aux trois circuits intégrateurs 12, 14 et 16 et interconnectés entre eux.

Le circuit intégrateur 12 comporte quatre entrées. Les entrées 20 et 32 sont définies comme les entrées 20 et 32 décrites en référence aux figures 1 et 2. L'entrée 18 est reliée directement à la borne d'entrée 4. La borne d'entrée 6 décrite en référence à la figure 1 définit la quatrième entrée du circuit intégrateur 12 via un interrupteur 17 et une capacité C31.

Le circuit intégrateur 212 comporte deux entrées 218 et 220. L'entrée 218 est reliée à l'entrée 42 du circuit intégrateur 36 et à la sortie du circuit intégrateur 16. La sortie du circuit intégrateur 212 forme l'entrée 222 du circuit intégrateur 214.

Le circuit intégrateur 214 comporte deux entrées 222 et 224. L'entrée 224 est reliée à la sortie du circuit intégrateur 216 et la sortie du circuit intégrateur 214 forme l'entrée 226 du circuit intégrateur 216.

Le circuit intégrateur 216 comporte deux entrées 226 et 228. L'entrée 228 est reliée à la sortie du circuit intégrateur 218 et la sortie du circuit intégrateur 216 forme l'entrée 230 du circuit intégrateur 218.

Le circuit intégrateur 218 comporte deux entrées 230 et 232. L'entrée 232 est reliée directement à la sortie du circuit intégrateur 218 qui définit la borne de sortie 10 du quadripôle de filtrage 200.

Les circuits intégrateurs 212, 214, 216 et 218 comprennent chacun un amplificateur opérationnel respectivement A6, A7, A8 et A9, une entrée non inverseuse reliée à la masse et une entrée inverseuse reliée aux différentes entrées desdits circuits intégrateurs via des capacités commutées.

Les entrées 218 et 220 du circuit intégrateur 212 sont définies respectivement par une capacité C50 et une capacité C51 et respectivement par un commutateur entrée I50 et un commutateur entrée I51. Un organe commutateur de liaison O6 via un noeud N6 commute les capacités C50 et C51 entre soit la masse et soit l'entrée inverseuse du circuit intégrateur 212.

Les entrées 222 et 224 du circuit intégrateur 214, les entrées 226 et 228 du circuit intégrateur 216 et les entrées 230 et 232 du circuit intégrateur 218 sont définies de la même façon que les entrées 218 et 220.

Chaque entrée inverseuse des circuits intégrateurs 212, 214, 216 et 218 est reliée respectivement par une capacité C58, C59, C60 et C61 à la sortie de l'amplificateur opérationnel associé à chaque circuit intégrateur.

Lorsque le quadripôle de filtrage 200 est de type elliptique, la sortie du circuit intégrateur 214 est reliée par une capacité C62 à l'entrée inverseuse du circuit intégrateur 16 et la sortie du circuit intégrateur 16 est reliée par une capacité C63 à l'entrée inverseuse du circuit intégrateur 214.

Le quadripôle de filtrage 200 est biphasé car les capacités commutées changent d'état selon deux états d'horloge disjoints comme ceux décrits en référence à la figure 2.

Bien entendu, d'autres circuits intégrateurs agencés selon la structure des intégrateurs 36 et 38 peuvent être branchés sur un quadripôle de filtrage comprenant n circuits intégrateurs agencés selon la structure en échelle des intégrateurs 12, 14, 16, 212, 214, 216 et 218.

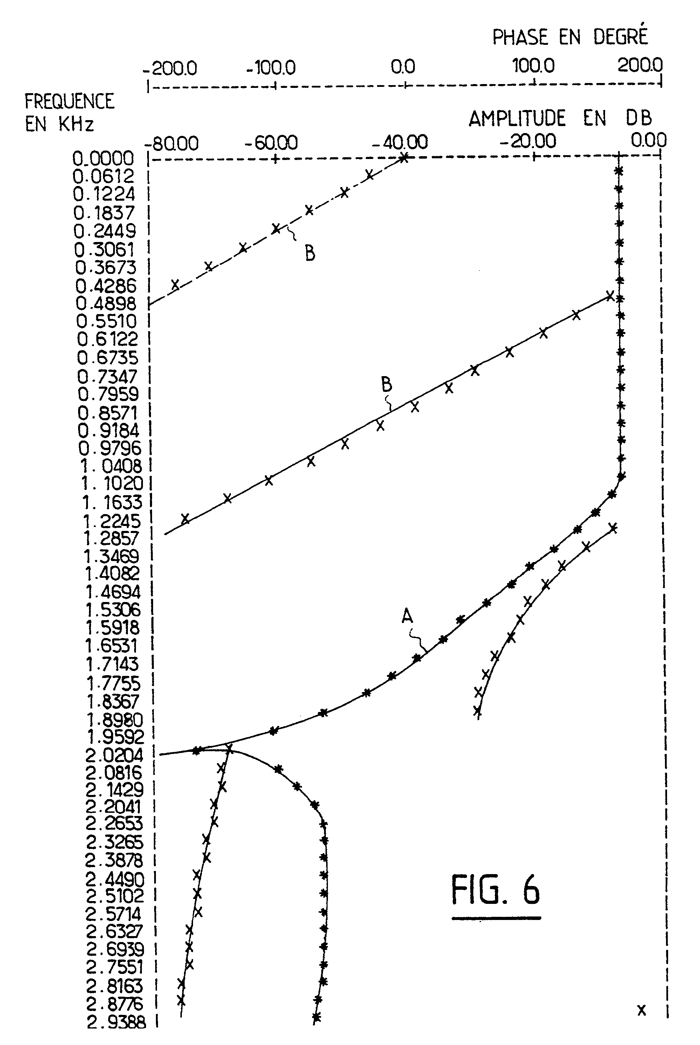

On fait maintenant référence à la figure 6 qui représente les courbes de réponse du filtre décrit en référence à la figure 5. Sur l'axe des ordonnées on a représenté les fréquences en kilohertz. Sur l'axe des abscisses on a représenté l'amplitude en dB et la phase en degrés.

On voit que la courbe de réponse en amplitude par rapport à la fréquence du filtre A est linéaire entre −60 dB et −5 dB approximativement. La variation linéaire de la phase du filtre en fonction de la fréquence est illustrée par les courbes B.

On a ainsi réalisé un quadripôle de filtrage 200 d'ordre 7 de type biphasé avec une courbe de réponse phase/fréquence linéaire.

## Revendications

1. Quadripôle de filtrage à capacités commutées, du type comprenant, entre deux bornes d'entrée (4, 6) et deux bornes de sortie (8, 10), au moins trois circuits intégrateurs (12, 14, 16) possédant chacun deux entrées équipées de capacités commutées selon deux états d'horloge disjoints, et qui sont interconnectés pour former un filtre échantillonné de réponse amplitude/fréquence choisie, caractérisé en ce qu'il comporte deux autres circuits intégrateurs (36, 38) dont les entrées respectives sont équipées de capacités commutées selon deux états d'horloge disjoints et qui sont interconnectés entre eux et avec les premiers pour linéariser la réponse phase/fréquence dudit filtre.

2. Quadripôle selon la revendication 1, dans lequel un premier circuit intégrateur (12) comporte deux entrées dont l'une (18) est reliée à la première borne d'entrée (4) et dont la sortie est reliée à la seconde borne d'entrée (6), dans lequel un second circuit intégrateur (14) comporte deux entrées dont la première (22) est reliée à la sortie du premier circuit intégrateur (12), et dont la sortie forme la seconde entrée (20) du premier circuit intégrateur (12), et dans lequel un troisième circuit intégrateur (16) comporte deux entrées dont la première (26) est reliée à la sortie du second circuit intégrateur (14), dont la seconde entrée (28) est reliée à la première borne de sortie (8) et dont la sortie est reliée à la seconde borne de sortie (10) ainsi qu'à la seconde entrée (24) du second circuit intégrateur (14), caractérisé en ce que
— les premier (12) et troisième (16) circuits intégrateurs sont munis d'une entrée supplémentaire (32, 34),
— en ce qu'un quatrième circuit intégrateur (36) comprend trois entrées, dont la première (40) est reliée à la sortie du premier circuit intégrateur (12) et la seconde (42) est reliée à la sortie du troisième circuit intégrateur (16) et dont la sortie est reliée aux entrées supplémentaires (32, 34) des premier et troisième circuits intégrateurs (12, 16), et en ce qu'un cinquième circuit intégrateur (38) comprend une seule entrée (46) reliée elle aussi à la sortie du quatrième circuit intégrateur (36) et dont la sortie est reliée à la troisième entrée (44) du quatrième circuit intégrateur (36).

3. Quadripôle selon la revendication 2, caractérisé en ce que certains au moins des circuits intégrateurs (36) comprennent : un amplificateur opérationnel (A4), une entrée non inverseuse reliée à la masse et une entrée inverseuse reliée aux différentes entrées (40, 42, 44) desdits circuits intégrateurs (36) via des capacités commutées (C21, C22, C23).

4. Quadripôle selon la revendication 3, caractérisé en ce que les différentes entrées (40, 42, 44) d'un circuit intégrateur (36) sont définies chacune par :
— une capacité (C23),
— un commutateur entrée (I9) propre à établir une liaison électrique entre l'une des armatures de la capacité (C23) et soit la masse soit l'entrée (44) et en ce qu'un organe commutateur de liaison (O3) est propre à établir une liaison électrique entre l'autre armature de la capacité (C23) et soit l'entrée inverseuse soit la masse.

5. Quadripôle selon les revendications 3 et 4, caractérisé en ce que l'organe commutateur de liaison (O3) comprend un commutateur propre à établir une liaison électrique entre un noeud (N3) et soit l'entrée inverseuse soit la masse tandis que les différentes autres armatures des capacités (C21, C22, C23) sont reliées ensemble au noeud (N3).

6. Quadripôle selon les revendications 3 et 4, caractérisé en ce que l'organe commutateur de liaison (O3) comprend plusieurs commutateurs (I13, I14, I15) propres chacun à établir une liaison électrique entre chaque autre armature des capacités (C21, C22, C23) et soit un point de contact électrique (47, 48, 50) soit la masse, chaque point de contact électrique (47, 48, 50) étant relié ensemble à l'entrée inverseuse du circuit intégrateur (36).

7. Quadripôle selon la revendication 3, caractérisé en ce que chaque entrée inverseuse des circuits intégrateurs (36) est reliée par une capacité (C25) à la sortie de l'amplificateur opérationnel (A4) de chaque circuit intégrateur (36).

8. Quadripôle selon la revendication 2, caractérisé en ce que la sortie du premier circuit intégrateur (12) est reliée par une capacité (C19) à l'entrée inverseuse de l'amplificateur du troisième circuit intégrateur (16) et en ce que la sortie du troisième circuit intégrateur (16) est reliée par une autre capacité (C20) à l'entrée inverseuse de l'amplificateur du premier circuit intégrateur (12), ce qui permet d'obtenir un filtre échantillonné à capacités commutées de type elliptique.

9. Quadripôle selon la revendication 1, caractérisé en ce que plusieurs circuits intégrateurs (212, 214, 216, 218 et 220) possédant chacun deux entrées équipées de capacités commutées selon deux états d'horloge disjoints sont interconnectés entre eux et avec les cinq circuits intégrateurs (12, 14, 16, 36 et 38) pour former un filtre échantillonné de réponse phase/fréquence linéaire de plusieurs ordres.

## Patentansprüche

1. Filter-Vierpol mit geschalteten Kapazitäten, enthaltend zwischen zwei Eingangsanschlüssen (4, 6) und zwei Ausgangsanschlüssen (8, 10) wenigstens drei Integratorkreise (12, 14, 16), die jeweils zwei Eingänge aufweisen, die mit Kapazitäten versehen sind, die in zwei getrennten Taktzuständen geschaltet sind und die miteinander verbunden sind, um ein Tastfilter zu bilden, das auf eine gewälte Amplitude/Frequenz anspricht, **dadurch gekennzeichnet**, daß er zwei weitere Integratorkreise (36, 38) enthält, deren Eingänge jeweils mit Kapazitäten versehen sind, die gemäß zwei getrennten Taktzuständen geschaltet sind und die miteinander und mit den erstgenannten verbunden sind, um das Phasen/Frequenz-Verhalten des Filters zu linearisieren.

2. Vierpol nach Anspruch 1, bei dem ein erster Integratorkreis (12) zwei Eingänge aufweist, von denen der eine (18) mit dem ersten Eingangsanschluß (4) verbunden ist und der Ausgang mit dem zweiten Eingangsanschluß (6) verbunden ist, und in dem ein zweiter Integratorkreis (14) zwei Eingänge aufweist, von denen der erste (22) mit dem Ausgang des ersten Integratorkreises (12) verbunden ist und der Ausgang den zweiten Eingang (20) des ersten Integratorkreises (12) bildet, und bei dem ein dritter Integratorkreis (16) zwei Eingänge aufweist, von denen der erste (26) mit de Ausgang des zweiten Integratorkreises (14) verbunden ist und der zweite Eingang (28) mit dem ersten Ausgangsanschluß (8) verbunden ist und der ausgang mit dem zweiten Ausgangsanschluß (18) sowie mit dem zweiten Eingang (24) des zweiten Integratorkreises (14) verbunden ist, **dadurch gekennzeichnet**, daß die ersten (12) und dritten (16) Integratorkreise mit einem zusätzlichen Eingang (32, 34) versehen sind,
daß ein vierter Integratorkreis (36) drei Eingänge aufweist, von denen der erste (40) mit dem Ausgang des ersten Integratorkreises (12) verbunden ist und der zweite (42) mit dem Ausgang des dritten Integratorkreises (16) verbinden ist und von dem der Ausgang mit den zusätzlichen Eingängen (32, 34) der ersten und dritten Integratorkreise (12, 16) verbunden sind, und daß ein fünfter Integratorkreis (38) einen einzigen Eingang (46) aufweist, der auch mit dem Ausgang des vierten Integratorkreises (6) verbunden ist und von dem der Ausgang mit dem dritten Eingang (44) des vierten Integratorkreises (36) verbunden ist.

3. Vierpol nach Anspruch 2, **dadurch gekennzeichnet**, daß wenigstens einige der Integratorkreise (36) enthalten : einen Operationsverstärker (A4), einen nichtinvertierenden Eingang, der mit Masse verbunden ist, und einen invertierenden Eingang, der mit unterschiedlichen Eingängen (40, 42, 44) der Integratorkreise (36) über geschaltete Kapazitäten (C21, C22, C23) verbunden ist.

4. Vierpol nach Anspruch 3, **dadurch gekennzeichnet**, daß die verschiedenen Eingänge (40, 42, 44) eines Integratorkreises (36) jeweils definiert sind durch :
eine Kapazität (C23),
einen Schalteingang (I9), der dazu dient, eine elektrische Verbindung zwischen einer der Elektroden der Kapazität (C23) und Masse oder dem Eingang (44) herzustellen und daß ein Verbindungsschaltorgan (O3) dazu dient, eine elektrische Verbindung zwischen der anderen Elektrode der Kapazität (C23) und dem invertierenden Eingang oder Masse herzustellen.

5. Vierpol nach den Ansprüchen 3 und 4, **dadurch gekennzeichnet**, daß das Verbindungsschaltorgan (O3) einen Schalter aufweist, der dazu dient, eine elektrische Verbindung zwischen einem Knoten (N3) und dem invertierenden Eingang oder Masse herzustellen, während die verschiedenen anderen Elektroden der Kapazitäten (C21, C22, C23) zusammen mit dem Knoten (N3) verbunden sind.

6. Vierpol nach den Ansprüchen 3 und 4, **dadurch gekennzeichnet**, daß das Verbindungsschaltorgan (O3) mehrere Schalter (I13, I14, I15) enthält, die dazu dienen, jeweils eine elektrische Verbindung zwischen jeder anderen Elektrode der Kapazitäten (C21, C22, C23) und einem elektrischen Kontaktpunkt (47, 4, 50) oder Masse herzustellen, wobei jeder elektrische Kontaktpunkt (47, 48, 50) mit dem invertierenden Eingang des Integratorkreises (36) zusammengeschaltet ist.

7. Vierpol nach Anspruch 3, **dadurch gekennzeichnet**, daß jeder invertierende Eingang der Integratorkreise (36) über eine Kapazität (C25) mit dem Ausgang des Operationsverstärkers (A4) jedes Integratorkreises (36) verbunden ist.

8. Vierpol nach Anspruch 2, **dadurch gekennzeichnet**, daß der Ausgang des ersten Integratorkreises (12) über eine Kapazität (C19) mit dem invertierenden Eingang des Verstärkers des dritten Integratorkreises (16) verbunden ist und daß der Ausgang des dritten Integratorkreises (16) über eine weitere Kapazität (C20) mit dem invertierenden Eingang des Verstärkers des ersten Integratorkreises (12) verbunden ist, was es ermöglicht, ein Tastfilter mit geschalteten Kapazitäten vom elliptischen Typ zu erzielen.

9. Vierpol nach Anspruch 1, **dadurch gekennzeichnet**, daß mehrere Integratorkreise (212, 214, 216, 218 und 220) jeweils zwei Eingänge besitzen, die mit Kapazitäten versehen sind, die in zwei verschiedene Taktzustände geschaltet sind und die untereinander und mit den fünf Integratorkreisen (12, 14, 16, 36 und 38) verbunden sind, um ein Tastfilter mit linearem Phasen/Frequenz-Gang mehrerer Ordnungen zu bilden.

## Claims

1. Switched capacitor four-terminal filter network of the type comprising, between two input terminals (4, 6) and two output terminals (8, 10), at least three integrating circuits (12, 14, 16) each possessing two inputs equipped with capacitors switched according to two disjoined clock states and which are interconnected to form a sampling filter for selected amplitude/frequency response, characterized in that it comprises two other integrating circuits (36, 38), the respective inputs of which are equipped with capacitors switched according to two disjoined clock states and which are interconnected to one another and to the first ones for linearizing the phase/frequency response of said filter.

2. Four-terminal filter network according to Claim 1, in which a first integrating circuit (12) comprises two inputs, of which the one (18) is connected to the first input terminal (4) and the output of which is connected to the second input terminal (6), in which a second integrating circuit (14) comprises two inputs, of which the first (22) is connected to the output from the first integrating circuit (12), and the output of which forms the second input (20) of the first integrating circuit (12), and in which a third integrating circuit (16) comprises two inputs, of which the first (26) is connected to the output of the second integrating circuit (14), of which the second input (28) is connected to the first output terminal (8), and the output of which is connected to the second output terminal (10) and to the second input (24) of the second integrating circuit (14), characterized in that

— the first (12) and third (16) integrating circuits are equipped with a supplementary input (32, 34),
— in that a fourth integrating circuit (36) comprises three inputs, of which the first (40) is connected to the output of the first integrating circuit (12) and the second (42) is connected to the output of the third integrating circuit (16), and the output of which is connected to the supplementary inputs (32, 34) of the first and third integrating circuits (12, 16), and in that a fifth integrating circuit (38) comprises a single input (46) itself also connected to the output of the fourth integrating circuit (36), and the output of which is connected to the third input (44) of the fourth integrating circuit (36).

3. Four-terminal filter network according to Claim 2, characterized in that at least some of the integrating circuits (36) comprise : an operational amplifier (A4), a non-inverting input connected to earth and an inverting input connected to the different inputs (40, 42, 44) of said integrating circuits (36) via switched capacitors (C21, C22, C23).

4. Four-terminal filter network according to Claim 3, characterized in that the different inputs (40, 42, 44) of an integrating circuit (36) are each defined by :
— a capacitor (C23),
— an input switch (I9) adapted for making an electrical connection between one of the plates of the capacitor (C23) and either earth or the input (44), and in that a connection switching element (O3) is adapted for making an electrical connection between the other plate of the capacitor (C23) and either the inverting input or earth.

5. Four-terminal filter network according to Claims 3 and 4, characterized in that the connection switching element (O3) comprises a switch adapted for making an electrical connection between a node (N3) and either the inverting input or earth, while the various other plates of the capacitors (C21, C22, C23) are together connected to the node (N3).

6. Four-terminal-filter network according to Claims 3 and 4, characterized in that the connection switching element (O3) comprises several switches (I13, I14, I15), each adapted for making an electrical connection between each other plate of the capacitors (C21, C22, C23) and either an electrical contact point (47, 48, 50) or earth, each electrical contact point (47, 48, 50) being connected together to the inverting input of the integrating circuit (36).

7. Four-terminal filter network according to Claim 3, characterized in that each inverting input of the integrating circuits (36) is connected by a capacitor (C25) to the output of the operational amplifier (A4) of each integrating circuit (36).

8. Four-terminal filter network according to Claim 2, characterized in that the output from the first integrating circuit (12) is connected by a capacitor (C19) to the inverting input of the amplifier of the third integrating circuit (16) and in that the output of the third integrating circuit (16) is connected by another capacitor (C20) to the inverting input of the amplifier of the first integrating circuit (12), which enables a sampling filter having switched capacitors of elliptical type to be obtained.

9. Four-terminal filter network according to Claim 1, characterized in that several integrating circuits (212, 214, 216, 218 and 220) each possessing two inputs equipped with capacitors switched according to two disjoined clock states are interconnected with one another and with the five integrating circuits (12, 14, 16, 36 and 38) to form a linear phase/frequency response sampling filter of several orders.

FIG.1

FIG.2

FIG. 3

FIG. 4

FIG. 5

EP 0 307 275 B1

FIG. 6